# EUROPEAN PATENT APPLICATION

(11) **EP 1 239 487 A1**
(43) Date of publication of application: **11.09.2002**
(21) Application number: 01302064.9
(22) Date of filing: 06.03.2001
(51) Int. Cl.: G11C 7/20, G11C 11/419, G11C 11/4072

(54) **Memory reset method and circuit**

(71) Applicant: STMicroelectronics Limited, Almondsbury, Bristol BS32 4SQ (GB)
(72) Inventor: Barnes, William Bryan, Almondsbury, Bristol BS32 4SQ (GB)
(74) Representative: Neobard, William John

(57) **Abstract**

It is often desirable to write a single value to all the cells in a memory. Usually this is done using separate reset circuitry. The normal write transistor provided for each column is dimensioned to be big enough to reliably overcome the pull-up of the p FET of a cell, and thus are not capable of writing to plural cells at once. If the write transistors are made larger, space is wasted and the memory is slower due to the extra capacitance.
In the embodiment all cells per column are connected to the positive rail via a single switch, and that switch turned off while writing to all cells. The switch is then turned on again which allows the cells to become actually reset. This allows for use of standard or optimised RAM cells to have flash clear.

## Description

The present invention relates to static memory circuits and more specifically to a method of operating such a memory for writing a single value to all memory cells in a column and to a circuit capable of writing a single value to all memory cells in a column.

An embodiment of the invention enables writing a single value to all cells in the memory.

It is often necessary to write a single logic value to a memory or part thereof. The situation arises especially at the time of power-on, when resetting may be needed to prevent random values appearing in the memory cells. Many circuits and techniques have been developed in the past, including writing sequentially first to one cell or group of cells and then to the next cell or group of cells. Most of the prior techniques are either slow or require more complex circuit arrangements, and hence chip area to be taken up. Equally prior techniques tends to prevent the use of standardised optimised memory cells.

An object of the present invention is to at least partly overcome the difficulties of the prior art.

One object of embodiments of the invention is to enable flash-clear of optimised memory cells. Another object of embodiments of the invention is to enable cheaper flash clear of a RAM.

According to a first aspect of the invention there is provided a method of operating a static semiconductor memory having plural bistable memory cells connectable to a pair of complementary bit lines, and write circuitry for providing a write potential on at least one of the pair of bit lines, wherein each bistable cell has a pair of cross-coupled transistors connected to a reference potential and a pair of loads for said transistors having a connection to a positive supply, the method comprising:
interrupting said connection to a positive supply;
connecting all of the bistable memory cells to the pair of complementary bit lines
operating the write circuitry to provide the write potential on the bit lines, whereby a selected one of the pair of cross-coupled transistors of each cell is made conductive; and
restoring said connection to a positive supply, whereby all said memory cells assume the same state.

According to a second aspect of the invention there is provided a method of operating a static semiconductor memory having plural bistable memory cells and plural pairs of complementary bit lines, said memory cells being connectable to a respective pair of complementary bit lines, and write circuitry for providing a write potential on one of each pair of bit lines, wherein each bistable cell has a pair of cross-coupled transistors connected to a reference potential and a pair of loads for said transistors having a connection to a positive supply, the method comprising:
interrupting said connection to a positive supply;
connecting all of the bistable memory cells to the corresponding pair of complementary bit lines;
operating the write circuitry to provide the write potential on the bit lines, whereby a selected one of the pair of cross-coupled transistors of each cell is made conductive; and:
   restoring said connection to a positive supply, whereby all said memory cells assume the same state.

According to a further aspect of the invention there is provided a static memory having a positive power supply rail and a reference rail, the memory comprising plural pairs of complementary bit lines, a plurality of bistable memory cells, each cell being associated with a corresponding pair of bit lines, enable circuitry for selectively connecting memory cells to each pair of bit lines and write circuitry for applying a selected logic level to one line of each pair of bit lines whereby a corresponding logic state is written to the connected memory cells, the memory further comprising switching circuitry for selectively connecting the memory cells to the positive supply node, and control circuitry for opening the switching circuitry while causing said enabling circuit to connect all said memory cells to their corresponding pairs of bit lines and causing the write circuitry to apply said selected level to said bit line.

The present invention recognises that where a memory has write circuitry adapted to write to one cell per column, it is not normally possible to use that write circuitry to write to the whole column. This is because the current capacity of the write circuitry - typically an n-type transistor for driving each bit line -is selected to drive only one cell at a desired speed, which cell is connected to the bit line via enabling pass gates operated by the word line. It would be possible to replace the write transistor for each bit line with a much larger device, but to do so would waste chip space. More importantly, it would mean that normal operations would be slower, due to the larger capacitance of the write device on the bit line.

A preferred but exemplary embodiment of the invention will now be described with reference to the accompanying drawings in which:
Figure 1 is a partial circuit diagram of one column of a static memory array and
Figure 2 is a partial circuit diagram of a static semiconductor memory array incorporating the present invention.

In the various like figures like reference numerals indicate like parts.

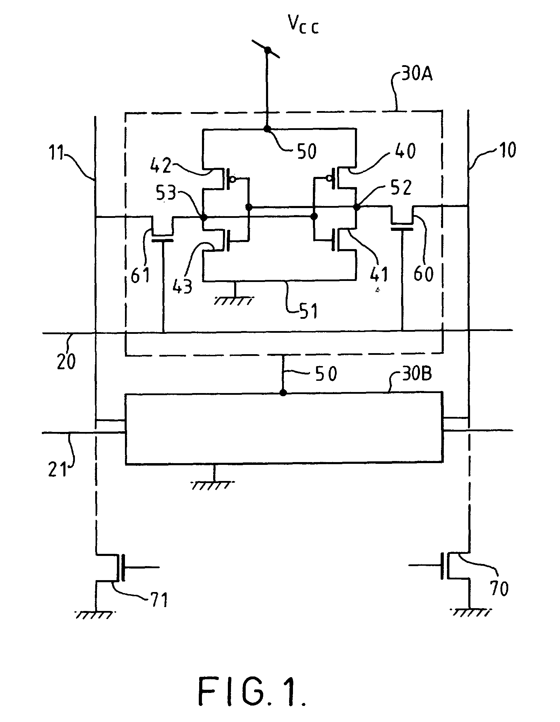

Referring to Figure 1, as is known to those skilled in the art a static semiconductor memory array comprises a plurality of complementary bit line pairs, of which only one pair 10, 11 is shown in the drawing. The memory array further has a plurality of row or word lines 20, 21 of which two are shown in the drawing. Bistable memory cells 30 are connected by the word lines to the bit lines in known fashion. Each bistable memory cell consists of two cross-coupled CMOS inverters with the first inverter having a P-type pull-up transistor 40 and an N-type pull-down transistor 41 connected in series between a power supply node 50 and a reference node 51 and having an intermediate node 52. The second inverter has a second P-type pull-up transistor 42 and a second N-type pull-down transistor 43, the two transistors being connected in series between the power and reference nodes 50, 51 and having an intermediate node 53. The gate electrodes of the first P-type pull-up transistor 40 and the first N-type pull-down transistor 41 are connected in common and to the second intermediate node 53. The gate electrode of the second P-type pull-up transistor 42 and the second N-type pull-down transistor 43 are connected in common and to the first intermediate node 53. The first intermediate node 52 is connected to the first bit line 10 via an N-type pass transistor 60 having a gate electrode connected to the first word line 20 and the second intermediate node 53 is connected to the second bit line 11 via a second N-type pass transistor 61 also having its gate connected to the first word line 20.

Such circuitry is well-known in the art and its operation will not be described herein. The complementary bit lines 10 and 11 are connectable to sense amplifier circuitry for reading the contents of a memory cell which has been addressed by activating a word line. Again, sense amplifier circuitry is well-known and will not be described herein.

Continuing to refer to Figure 1 each bit line 10, 11 has a respective write transistor 70, 71 connected to it for selectively connecting the corresponding bit line to the reference potential. These transistors enable a logic 0 to be applied via the bit line to one or other side of the bistable circuit, thus causing the bistable to adopt a selected desired state. If for example, the cell 30 of Figure 1 currently has node 52 at Vcc then due to the circuit connection node 53 will be substantially at reference. To write the opposite state to the memory cell bit line 20 is activated thus connecting first intermediate node 52 to bit line 10 and second intermediate node 53 to bit line 11. Application of a positive potential to the gate of the first write transistor 70 causes the potential at first intermediate 52 to fall. Provided the current carrying ability of the first write transistor 70 is greater than the pull-up capability of the first P-type pull-up transistor 40, the potential at first intermediate node 52 will fall sufficiently for the second P-type pull-up transistor 42 to begin to turn on and the second N-type pull-down transistor 43 to begin to turn off. This has the consequence that second intermediate node 53 will begin to rise in potential - bearing in mind that second write transistor 71 remains off. Ultimately, the first N-type pull-down transistor 41 will be fully on and the first P-type pull-up transistor will be fully off with first intermediate node 52 at reference potential.

It will be seen from the above description that the requirement for the write transistor 70, 71 is that they are capable of overcoming the current supplied by the corresponding P-type pull-up transistor 40, 42. It is desirable to design the write transistors to be as small as possible whilst being guaranteed being able to overcome the P-type pull-up transistors so as to firstly reduce the size of the transistors and, as a consequence, reduce the capacity of loading of the bit lines.

If circuitry were provided to enable more than one word line then the write transistors would need to be increased in size if they were to overcome the pull-up effect of two P transistors at once. However, this situation does not normally arise.

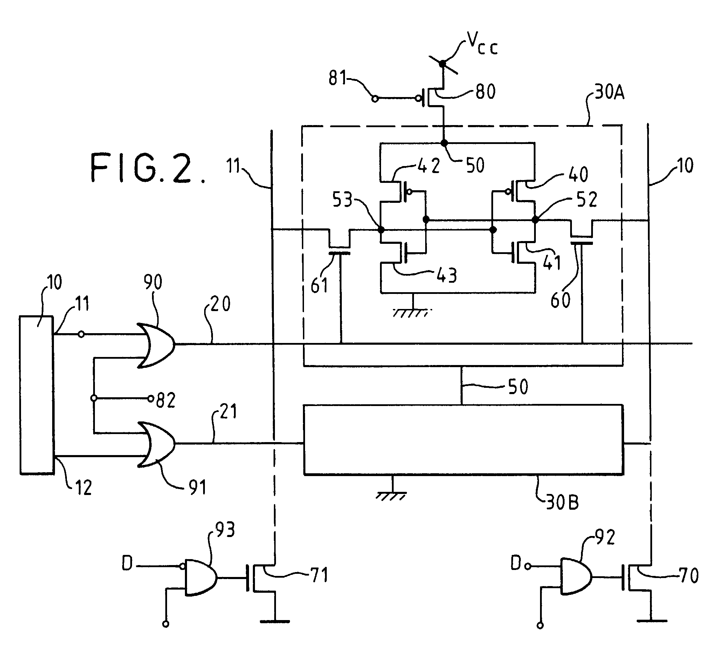

Referring now to Figure 2, it will be seen that each bistable circuit of a column is connected to a common power supply node 50 which is connected to the positive supply Vcc via a column power transistor 80. This transistor 80 is a P-type device and has a gate connected to a control node 81. The word lines 20, 21 are, known to those skilled in the art connected to an address decoder 10 which has a first output 11 for selecting the first word line 20, a second output 12 for selecting the second word line 21 and similar outputs for selecting each successive word line. However, referring to Figure 2 shows that a respective OR gate 90, 91 is connected between respective outputs 11, 12 of the address decoder that the corresponding word line 20, 21. The OR gates are two input gates, and the second inputs of all of the OR gates are connected together to a control terminal 82.

The gates of the write transistor 70, 71 are connected to respective gates 92, 93 as known to those skilled in the art. The particular gate arrangement shown is purelyexemplary and allows for :
(data=1).writeenable; and
(data=0).writeenable

Other gating arrangements could be used as desired.

In normal operation the first control input 81 and the second control 82 have a logic 0 applied to them whereby the column power transistor 80 for each column of the memory is activated and the column power node 50 is thereby connected to the positive supply terminal Vcc. Equally the OR gates 90, 91 will only provide a logic 1 output on their corresponding word lines when the corresponding output of the address decoder 10 is enabled.

To write to all bistable cells in a column, logic 1 is provided to the first and second control inputs 81, 82. The effect of this is firstly to turn off the column power transistors 80 thus allowing the column power modes 50 to become undriven and, at the same time, to cause all of the word lines 20, 21 to be asserted, thus connecting all memory cells in the column, and additionally all memory cells in the memory to their corresponding bit lines.

It is then possible for a desired one of each of the bit line pairs to be driven low by selecting one of the write transistors 70, 71 and this will allow the selected one of the nodes 52, 53 to be driven low thus discharging the stored charge at the corresponding intermediate node. When the first and second control nodes 81, 82 are then returned to logic 0 the column power node 50 rises and the P-type pull-up transistor opposite the discharged node 52, 53 comes into conduction and causes the bistable to latch.

It will be seen that the arrangement disclosed allows setting or resetting of an entire memory, or a column of a memory. The disclosed embodiment does not add capacitive loading to the bit lines and the bit lines themselves remain symmetrically loaded. The ability to set or reset the memory simultaneously is achieved with only a small number of modifications which do not consume a large chip area.

## Claims

1. A method of operating a static semiconductor memory having plural bistable memory cells connectable to a pair of complementary bit lines, and write circuitry for providing a write potential on one of the pair of bit lines, wherein each bistable cell has a pair of cross-coupled transistors connected to a reference potential and a pair of loads for said transistors having a connection to a positive supply, the method comprising:
interrupting said connection to a positive supply;
connecting all of the bistable memory cells to the pair of complementary bit lines;
operating the write circuitry to provide the write potential on the bit lines, whereby a selected one of the pair of cross-coupled transistors of each cell is made conductive; and:
restoring said connection to a positive supply, whereby all said memory cells assume the same state.

2. A method of operating a static semiconductor memory having plural bistable memory cells and plural pairs of complementary bit lines, said memory cells being connectable to a respective pair of complementary bit lines, and write circuitry for providing a write potential on one of each pair of bit lines, wherein each bistable cell has a pair of cross-coupled transistors connected to a reference potential and a pair of loads for said transistors having a connection to a positive supply, the method comprising:
interrupting said connection to a positive supply;
connecting all of the bistable memory cells to the corresponding pair of complementary bit lines;
operating the write circuitry to provide the write potential on the bit lines, whereby a selected one of the pair of cross-coupled transistors of each cell is made conductive; and:
restoring said connection to a positive supply, whereby all said memory cells assume the same state.

3. A static memory having a positive power supply rail and a reference rail, the memory comprising plural pairs of complementary bit lines, a plurality of bistable memory cells, each cell being associated with a corresponding pair of bit lines, enable circuitry for selectively connecting memory cells to each pair of bit lines and write circuitry for applying a selected logic level to one line of each pair of bit lines whereby a corresponding logic state is written to the connected memory cells, the memory further comprising switching circuitry for selectively connecting the memory cells to the positive supply rail, and control circuitry for opening the switching circuitry while causing said enabling circuit to connect all said memory cells to their corresponding pairs of bit lines and causing the write circuitry to apply said selected level to said bit line.

4. The circuit of claim 3 wherein said memory cells are disposed in columns, each column being connected to a single pair of complementary bit lines, wherein said memory cells of a column have a common positive supply node, and wherein said switching circuitry comprises a respective transistor connected between each common positive supply node and said positive supply rail.

5. The circuit of claim 3 or 4, wherein said memory comprises a plurality of word lines, the word lines being connected to addressing circuitry having said plurality of outputs for selecting a single one of said word lines, said memory cells being disposed on respective word lines, whereby said addressing circuitry operates to connect a respective single one of said memory cells to each pair of bit lines, the memory further comprising logic circuitry having first inputs, a second input and said plurality of outputs, said first inputs receiving said outputs of said addressing circuitry, said plurality of outputs being connected to said plurality of word lines and wherein said second output is for causing said logic circuitry simultaneously to select all of said word lines.
